# EUROPEAN PATENT APPLICATION

(11) **EP 4 852 054 A1**
(43) Date of publication of application: **09.12.2026**
(21) Application number: 25767243.6
(22) Date of filing: 26.02.2025
(51) Int. Cl.: H01L 21/67

(54) **GAS INTAKE ASSEMBLY, SEMICONDUCTOR PROCESS CHAMBER AND SEMICONDUCTOR PROCESS METHOD**

(30) Priority: 07.03.2024 CN 202410263836
(71) Applicant: Beijing NAURA Microelectronics Equipment Co., Ltd., Beijing 100176 (CN)
(72) Inventor: LIU, He, Beijing 100176 (CN); JI, Ankuan, Beijing 100176 (CN); LIN, Yuanwei, Beijing 100176 (CN); ZHANG, Xinyi, Beijing 100176 (CN); TONG, Xin, Beijing 100176 (CN)
(74) Representative: Cohausz & Florack
(86) International application number: PCT/CN2025/079232
(87) International publication number: WO 2025/185503

(57) **Abstract**

The present disclosure provides a gas inlet assembly, a semiconductor process chamber, and a semiconductor process method, and belongs to the technical field of semiconductor technology. The gas inlet assembly includes a gas inlet window and a switching valve plate connected to each other. The gas inlet window is provided with a first gas inlet port and a second gas inlet port. The switching valve plate is movable relative to the gas inlet window between a first position and a second position, and the switching valve plate is provided with a gas passage, the gas passage communicating with a gas outlet end of the gas inlet assembly. When the switching valve plate is at the first position, the first gas inlet port is in communication with the gas passage and the second gas inlet port is disconnected from the gas passage. When the switching valve plate is at the second position, the second gas inlet port is in communication with the gas passage and the first gas inlet port is disconnected from the gas passage. In this way, by adjusting the position of the switching valve plate, the process gas from the previous process can be directly cut off at the position of the gas inlet window, thereby preventing residual gas from the previous process from participating in the subsequent process and helping improve the process performance.

## Description

### TECHNICAL FIELD

The present disclosure pertains to the field of semiconductor technology and specifically relates to a gas inlet assembly, a semiconductor process chamber, and a semiconductor process method.

### BACKGROUND

In the field of semiconductor processing, the Bosch process refers to a process in integrated circuit manufacturing in which a thin film is deposited on the lateral edge of an etched feature to prevent or reduce lateral etching, and mainly includes switching between an etching process dominated by fluorine-based gas and a deposition process dominated by fluorocarbon gas.

In the related art, a semiconductor process chamber includes a chamber body, a deposition gas supply apparatus, and an etching gas supply apparatus. The deposition gas supply apparatus communicates with the interior of the chamber body through a first pipeline, and the etching gas supply apparatus communicates with the interior of the chamber body through a second pipeline. The first pipeline and the second pipeline are each provided with a control valve, and the control valves are used to control opening and closing of the first pipeline and the second pipeline, thereby controlling deposition gas or etching gas to enter the chamber body and achieving switching between an etching process and a deposition process.

When the control valve controls the first pipeline to be open and the second pipeline to be closed, the deposition gas enters the chamber body, and the etching gas is cut off. However, a portion of the etching gas remaining in the second pipeline also enters the chamber body, thereby mixing with the deposition gas and participating in the process. Similarly, when the control valve controls the first pipeline to be closed and the second pipeline to be open, the deposition gas is cut off, and the etching gas enters the chamber body. However, a portion of the deposition gas remaining in the first pipeline also enters the chamber body, thereby mixing with the etching gas and participating in the process. Therefore, when gases are switched, the process gas remaining from the previous process participates in the subsequent process, causing an uneven scalloped structure to be formed on the etched sidewall. The rough sidewall adversely affects subsequent processes, thereby reducing the yield of devices.

### SUMMARY

Embodiments of the present disclosure are intended to provide a gas inlet assembly, a semiconductor process chamber, and a semiconductor process method, which can solve the problem in the related art that residual gas in the gas inlet assembly during gas switching affects the process performance.

In a first aspect, embodiments of the present disclosure provide a gas inlet assembly, including a connected gas inlet window and a switching valve plate. The gas inlet window is provided with a first gas inlet port and a second gas inlet port. The switching valve plate is movable relative to the gas inlet window between a first position and a second position, and the switching valve plate is provided with a gas passage, the gas passage being in communication with a gas outlet end of the gas inlet assembly.

When the switching valve plate is located at the first position, the first gas inlet port is in communication with the gas passage, and the second gas inlet port is disconnected from the gas passage. When the switching valve plate is located at the second position, the second gas inlet port is in communication with the gas passage, and the first gas inlet port is disconnected from the gas passage.

In a second aspect, embodiments of the present disclosure further provide a gas inlet assembly, including a first gas inlet unit and a second gas inlet unit.

The first gas inlet unit includes a first gas inlet pipe, a first gas extraction pipe, and a first switching valve plate. A gas inlet port of the first gas extraction pipe and a gas outlet port of the first gas inlet pipe are arranged side by side. The first switching valve plate is rotatably disposed at the gas inlet port of the first gas extraction pipe and the gas outlet port of the first gas inlet pipe.

The second gas inlet unit includes a second gas inlet pipe, a second gas extraction pipe, and a second switching valve plate. A gas inlet port of the second gas extraction pipe and a gas outlet port of the second gas inlet pipe are arranged side by side. The second switching valve plate is rotatably disposed at the gas inlet port of the second gas extraction pipe and the gas outlet port of the second gas inlet pipe.

The first gas inlet unit and the second gas inlet unit are alternately in communication with the gas outlet end of the gas inlet assembly.

In a third aspect, embodiments of the present disclosure further provide a semiconductor process chamber, including a chamber body and the above-described gas inlet assembly, where the gas outlet end of the gas inlet assembly is in communication with the chamber body.

In a fourth aspect, embodiments of the present disclosure further provide a semiconductor process method applied to the gas inlet assembly in the foregoing first aspect, the method including:

At the first process operation, the switching valve plate is controlled to move to the first position, such that the first gas is introduced into the chamber body through the first gas inlet port.

At the second process operation, the switching valve plate is controlled to move to the second position, such that the second gas is introduced into the chamber body through the second gas inlet port.

The first process operation and the second process operation are performed alternately.

In a fifth aspect, embodiments of the present disclosure further provide a semiconductor process method applied to the gas inlet assembly in the foregoing second aspect, the method including:

At the first process operation, the first gas inlet unit is controlled to be in communication with the gas outlet end of the gas inlet assembly, such that the first switching valve plate is located at a position blocking the gas inlet port of the first gas extraction pipe, and the second switching valve plate is in a rotating state.

At the second process operation, the second gas inlet unit is controlled to be in communication with the gas outlet end of the gas inlet assembly, such that the second switching valve plate is located at a position blocking the gas inlet port of the second gas extraction pipe, and the first switching valve plate is in a rotating state.

In the embodiments of the present disclosure, in the solution in which the gas inlet assembly includes a gas inlet window and a switching valve plate, by changing the position of the switching valve plate relative to the gas inlet window, the first gas inlet port can be brought into communication with the gas outlet end of the gas inlet assembly, or the second gas inlet port can be brought into communication with the gas outlet end of the gas inlet assembly, while the gas outlet end of the gas inlet assembly remains in communication with the chamber body. Since the gas inlet window is located at the top of and adjacent to the chamber body, the switching valve plate directly cuts off the process gas from the previous process at the position of the gas inlet window, thereby effectively preventing residual gas from the previous process from entering the chamber body and participating in the subsequent process, avoiding mixing of the two process gases during the process, and helping improve the process performance. Moreover, because the switching valve plate is disposed adjacent to the chamber body, the process gas enters the chamber body more quickly, thereby avoiding gas inlet delay caused by the flow of the process gas through the pipeline. The gas inlet delay time is effectively shortened, such that the pressure control process of the chamber body during the two processes can also be performed more quickly and accurately, thereby making the pressure difference in the chamber body during the two processes easier to control and helping improve the process performance.

In the solution in which the gas inlet assembly includes a first gas inlet unit and a second gas inlet unit, the first gas inlet unit and the second gas inlet unit are alternately in communication with the gas outlet end of the gas inlet assembly. When the first gas inlet unit is in communication with the gas outlet end of the gas inlet assembly, the second switching valve plate can rotate to a position at which the second gas extraction pipe is opened, and the second gas extraction pipe extracts gas from the second gas inlet pipe, i.e., extracts the process gas from the second gas inlet pipe, thereby preventing residual process gas from entering the chamber body and mixing with the process gas of the subsequent process to participate in the subsequent process. Similarly, when the second gas inlet unit is in communication with the gas outlet end of the gas inlet assembly, the first switching valve plate can rotate to a position at which the first gas extraction pipe is opened, and the first gas extraction pipe extracts gas from the first gas inlet pipe, i.e., extracts the process gas from the first gas inlet pipe, thereby preventing residual process gas from entering the chamber body and mixing with the process gas of the subsequent process to participate in the subsequent process, helping improve the process performance and thereby helping improve the yield of devices.

### BRIEF DESCRIPTION OF THE DRAWINGS

FIG. 1 is a schematic structural diagram of a semiconductor process chamber according to an embodiment of the present disclosure;
FIG. 2 is a schematic structural diagram of a gas inlet assembly according to an embodiment of the present disclosure;
FIG. 3 is a cross-sectional view of the gas inlet assembly when the switching valve plate is at the first position according to an embodiment of the present disclosure;
FIG. 4 is a cross-sectional view of the gas inlet assembly when the switching valve plate is at the second position according to an embodiment of the present disclosure;
FIG. 5 is a top view of a flow equalization plate according to an embodiment of the present disclosure;
FIG. 6 is a partial schematic diagram of the flow equalization plate according to an embodiment of the present disclosure;
FIG. 7 is a schematic structural diagram of the pressure control valve when the exhaust port is in a closed state according to an embodiment of the present disclosure;
FIG. 8 is a schematic operation diagram of the pressure control valve when the exhaust port is in an open state according to an embodiment of the present disclosure;
FIG. 9 is a flowchart of the semiconductor process method according to an embodiment of the present disclosure;
FIG. 10 is a timing diagram of the semiconductor process method according to an embodiment of the present disclosure;
FIG. 11 is a schematic structural diagram of a semiconductor process chamber according to another embodiment of the present disclosure;
FIG. 12 is a schematic structural diagram of a gas inlet assembly according to another embodiment of the present disclosure;
FIG. 13 is a schematic operation diagram of the first rotary valve plate according to another embodiment of the present disclosure.

Description of Reference Numerals:
100-chamber body, 101-gas inlet port, 110-base, 111-wafer, 120-liner,
200-gas inlet assembly, 210-gas inlet window, 211-first gas inlet port, 212-second gas inlet port, 220-switching valve plate, 221-first gas passage section, 222-second gas passage section, 231-first blocking member, 232-second blocking member, 241-first stopper, 242-second stopper, 251-first fixation member, 252-second fixation member, 260-flow equalization plate, 261-flow equalization groove, 262-flow equalization hole, 271-first sealing member, 272-second sealing member, 273-third sealing member,
223-first switching valve plate, 224-second switching valve plate,
281-first gas inlet pipe, 282-second gas inlet pipe, 283-first gas extraction pipe, 284-second gas extraction pipe, 285-gas outlet pipe, 285a-main pipeline, 285b-first pipe section, 285c-second pipe section,
291-third control valve, 292-fourth control valve,
300-vacuum pump, 310-molecular pump, 320-dry pump,
400-pressure control valve, 410-valve plate, 420-driving member,
510-first gas mass flow controller, 520-first gas extraction pipeline, 530-first control valve, 531-first needle valve, 532-first pneumatic shut-off valve,
610-second gas mass flow controller, 620-second gas extraction pipeline, 630-second control valve, 631-second needle valve, 632-second pneumatic shut-off valve.

### DETAILED DESCRIPTION OF THE EMBODIMENTS

The technical solutions in the embodiments of the present disclosure will be clearly described below with reference to the accompanying drawings in the embodiments of the present disclosure. Obviously, the described embodiments are merely some embodiments of the present disclosure, rather than all embodiments. All other embodiments obtained by a person of ordinary skill in the art based on the embodiments of the present disclosure fall within the scope of the present disclosure.

The terms "first," "second," and the like in the specification and claims of the present disclosure are used to distinguish similar objects rather than to describe a particular order or sequence. It should be understood that the terms used here are interchangeable under appropriate circumstances, so that the embodiments of the present disclosure can be implemented in sequences other than those illustrated or described herein. In addition, the objects distinguished by "first," "second," and the like are generally of the same type and do not limit the number of such objects. For example, a first object may be one object or a plurality of objects. In addition, "and/or" in the specification and claims indicates at least one of the connected objects, and the character "/" generally indicates that the associated objects before and after it are in an "or" relationship.

The gas inlet assembly, semiconductor process chamber, and semiconductor process method provided in the embodiments of the present disclosure will be described in detail below with reference to the accompanying drawings through specific embodiments and application scenarios.

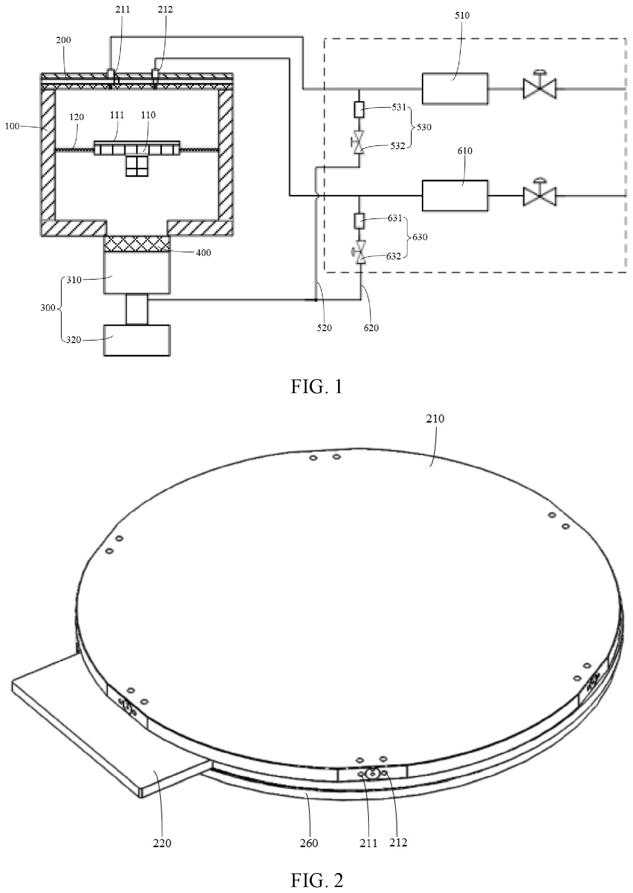

In some embodiments of the present disclosure, as shown in FIGS. 1 and 2, the gas inlet assembly 200 may include a gas inlet window 210 and a switching valve plate 220. The gas inlet window 210 is configured to introduce different gases, and the switching valve plate 220 is configured to switch the gases, such that the gases flow toward the gas outlet end of the gas inlet assembly 200. For example, the gases introduced through the gas inlet window 210 may be different process gases, such as a deposition gas and an etching gas. In other words, the gas inlet window 210 is configured to introduce the deposition gas and the etching gas, while the switching valve plate 220 is configured to switch the deposition gas or the etching gas to flow toward the gas outlet end of the gas inlet assembly 200. More specifically, the gas inlet assembly 200 alternately introduces the deposition gas and the etching gas into the chamber body 100 to implement the Bosch process.

As shown in FIG. 2, the switching valve plate 220 is disposed opposite to and adjacent to the gas inlet window 210. The gas inlet window 210 is provided with a first gas inlet port 211 and a second gas inlet port 212. For example, the first gas inlet port 211 is configured to introduce an etching gas, and the second gas inlet port 212 is configured to introduce a deposition gas. Of course, the first gas inlet port 211 and the second gas inlet port 212 may also respectively introduce other different types of process gases.

In the embodiment shown in FIG. 1, the first gas inlet port 211 may be in communication with an external first gas mass flow controller 510, and the second gas inlet port 212 may be in communication with an external second gas mass flow controller 610.

As shown in FIGS. 2 to 4, the switching valve plate 220 is connected to the gas inlet window 210. The switching valve plate 220 is configured to control whether the first gas inlet port 211 and the second gas inlet port 212 are in communication with the gas outlet end of the gas inlet assembly 200. The switching valve plate 220 is movable relative to the gas inlet window 210. In some embodiments, the switching valve plate 220 may be movable relative to the gas inlet window 210, and may be driven to move manually or by a translation drive member. For example, the translation drive member may be a linear driving member such as a linear module or a cylinder. In other embodiments, the switching valve plate 220 may also be rotatable relative to the gas inlet window 210. The switching valve plate 220 rotates within its own plane so that the gas passage is brought into communication with the first gas inlet port 211 or the second gas inlet port 212. The switching valve plate 220 may be rotated manually or by a drive source. For example, the drive source may be a motor, a pneumatic motor, or another drive source capable of providing rotational power.

The switching valve plate 220 is movable relative to the gas inlet window 210 between a first position and a second position. The switching valve plate 220 is provided with a gas passage, and the gas passage is in communication with the gas outlet end of the gas inlet assembly 200. When the switching valve plate 220 is at the first position, the first gas inlet port 211 is in communication with the gas passage, and the second gas inlet port 212 is disconnected from the gas passage. At this time, the first gas enters the chamber body 100 through the gas inlet assembly 200, thereby initiating a first process. When the switching valve plate 220 is at the second position, the second gas inlet port 212 is in communication with the gas passage, and the first gas inlet port 211 is disconnected from the gas passage. At this time, the second gas enters the chamber body 100 through the gas inlet assembly 200, thereby initiating a second process. For example, the first gas introduced through the first gas inlet port 211 is an etching gas, and the first process is an etching process. The second gas introduced through the second gas inlet port 212 is a deposition gas, and the second process is a deposition process. In this way, the switching valve plate 220 only needs to move a relatively short distance so that the gas passage therein is correspondingly brought into communication with the first gas inlet port 211 or the second gas inlet port 212, thereby switching between the first gas and the second gas.

That is, by changing the position of the switching valve plate 220, the first gas at the first gas inlet port 211 or the second gas at the second gas inlet port 212 can rapidly enter the chamber body 100 through the gas inlet assembly 200.

In the related art, the control valve is located relatively far from the chamber body. Therefore, when the control valve switches gases, a large amount of process gas from the previous process still remains in the pipeline between the control valve and the chamber body, and enters the chamber body together with the gas for the subsequent process to participate in the subsequent process, thereby causing an uneven scalloped structure to be formed on the etched sidewall.

In this embodiment, by changing the position of the switching valve plate 220, the first gas inlet port 211 can be brought into communication with the gas outlet end of the gas inlet assembly 200, or the second gas inlet port 212 can be brought into communication with the gas outlet end of the gas inlet assembly 200, while the gas outlet end of the gas inlet assembly 200 remains in communication with the chamber body 100. Since the gas inlet window 210 is located at the top of the chamber body 100, the switching valve plate 220 directly cuts off the process gas from the previous process at the position of the gas inlet window 210. In other words, by disposing the switching valve plate 220 at the position of the gas inlet window 210, the distance between the switching valve plate 220 and the chamber body 100 is greatly reduced, thereby reducing to an almost negligible level the volume between the switching valve plate 220 and the chamber body 100 in which residual gas from the previous process can remain, effectively preventing residual gas from the previous process from entering the chamber body 100 and participating in the subsequent process, thereby preventing two process gases from mixing during the process and helping improve the process performance. Moreover, because the switching valve plate 220 is disposed adjacent to the chamber body 100, the process gas enters the chamber body 100 more quickly, thereby avoiding gas inlet delay caused by the flow of the process gas through the pipeline. The gas inlet delay time is effectively shortened, such that the pressure control process of the chamber body 100 during the two processes can also be performed more quickly and accurately, thereby making the pressure difference in the chamber body 100 during the two processes easier to control.

In some embodiments, the first gas inlet port 211 is configured to introduce an etching gas, and the second gas inlet port 212 is configured to introduce a deposition gas. The two processes are an etching process and a deposition process, respectively. The gas inlet assembly 200 in this embodiment can be used in a Bosch etching process. Rapid switching between the etching process and the deposition process can effectively prevent an uneven scalloped structure from being formed on the sidewall of a deep hole produced by etching, making the sidewall of the deep hole smoother, avoiding adverse effects on subsequent processes, and helping improve the yield of devices.

In other embodiments, as shown in FIG. 2, the first gas inlet ports 211 and the second gas inlet ports 212 are arranged in pairs. Multiple pairs of first gas inlet ports 211 and second gas inlet ports 212 are circumferentially spaced around the gas inlet window 210. In the example shown in FIG. 2, six pairs of first gas inlet ports 211 and second gas inlet ports 212 are illustratively shown. A person skilled in the art will appreciate that a greater or smaller number of pairs of first gas inlet ports 211 and second gas inlet ports 212 is also feasible. Correspondingly, a plurality of gas passages are arranged at intervals, and each gas passage corresponds to a respective pair of first gas inlet ports 211 and second gas inlet ports 212. In this embodiment, by providing multiple pairs of second gas inlet ports 212 and first gas inlet ports 211, multiple second gas inlet ports 212 can simultaneously introduce gas or multiple first gas inlet ports 211 can simultaneously introduce gas, thereby increasing the gas outlet area while improving gas inlet efficiency and process efficiency, which helps improve gas inlet uniformity.

For example, the gas inlet window 210 may have a circular structure, and the second gas inlet ports 212 and the first gas inlet ports 211 may be formed on the circumferential surface of the gas inlet window 210. However, this is not limiting. In some other embodiments, the second gas inlet ports 212 and the first gas inlet ports 211 may also be formed on the upper end surface of the gas inlet window 210. The embodiments of the present disclosure do not impose any limitation on the locations at which the second gas inlet ports 212 and the first gas inlet ports 211 are formed.

In this embodiment, for example, six pairs of second gas inlet ports 212 and first gas inlet ports 211 are circumferentially spaced around the gas inlet window 210, and, for example, six gas passages are arranged at intervals, each gas passage corresponding to a respective pair of second gas inlet ports 212 and first gas inlet ports 211.

Of course, in other embodiments, the gas inlet window 210 may also be provided with one first gas inlet port 211 and one second gas inlet port 212.

In the embodiment shown in FIGS. 1 to 4, the gas inlet assembly 200 further includes a blocking member disposed between the gas inlet window 210 and the switching valve plate 220. The gas passage includes a first gas passage section 221 and a second gas passage section 222. An outlet end of the first gas passage section 221 and an outlet end of the second gas passage section 222 are respectively in communication with the gas outlet end of the gas inlet assembly 200. The blocking member selectively blocks the first gas passage section 221 or the second gas passage section 222 according to the position of the switching valve plate 220. For example, the blocking member may be an elastic structure or a rigid structure. The embodiments of the present disclosure do not specifically limit the structure of the blocking member.

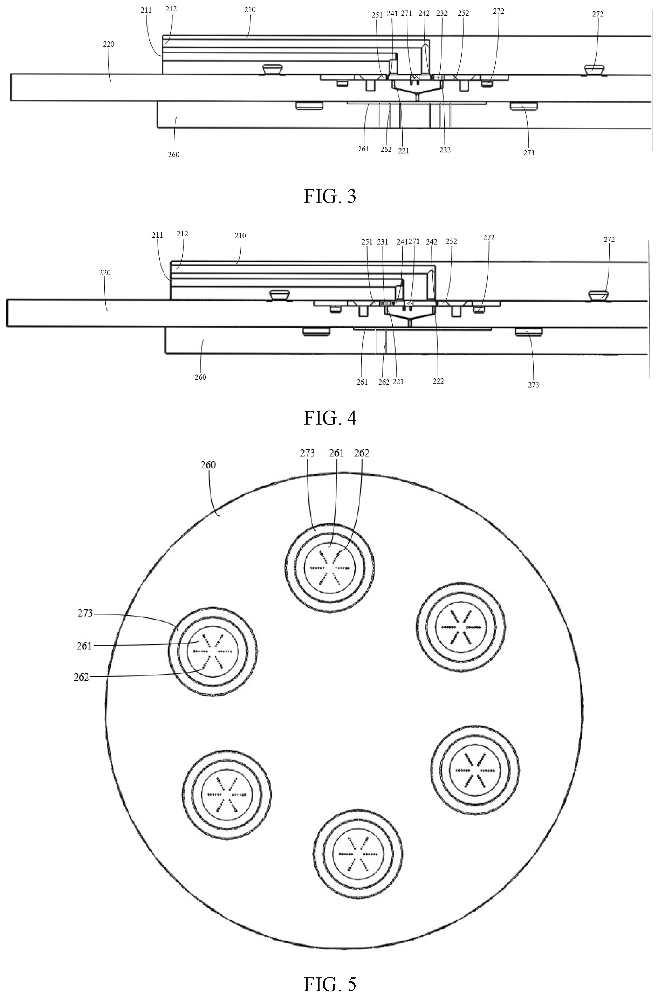

Referring to FIG. 3, when the switching valve plate 220 is at the first position, the first gas inlet port 211 is in communication with the inlet end of the first gas passage section 221, and the blocking member blocks the inlet end of the second gas passage section 222, such that the second gas inlet port 212 cannot communicate with the second gas passage section 222. Referring to FIG. 4, when the switching valve plate 220 is at the second position, the second gas inlet port 212 is in communication with the inlet end of the second gas passage section 222, and the blocking member blocks the inlet end of the first gas passage section 221, such that the first gas inlet port 211 cannot communicate with the first gas passage section 221.

That is, the first gas passage section 221 and the second gas passage section 222 each have an inlet end and an outlet end. The outlet end of the first gas passage section 221 and the outlet end of the second gas passage section 222 are respectively in communication with the gas outlet end of the gas inlet assembly 200. When the switching valve plate 220 is at the first position shown in FIG. 3, the first gas inlet port 211 is in communication with the inlet end of the first gas passage section 221, and the blocking member blocks the inlet end of the second gas passage section 222. When the switching valve plate 220 is at the second position shown in FIG. 4, the second gas inlet port 212 is in communication with the inlet end of the second gas passage section 222, and the blocking member blocks the inlet end of the first gas passage section 221.

For example, when the switching valve plate 220 is at the first position, the first gas inlet port 211 is aligned with the first gas passage section 221, and the second gas inlet port 212 is offset from the second gas passage section 222. When the switching valve plate 220 is at the second position, the first gas inlet port 211 is offset from the first gas passage section 221, and the second gas inlet port 212 is aligned with the second gas passage section 222.

According to the position of the switching valve plate 220, the blocking member directly blocks the first gas passage section 221 or the second gas passage section 222, thereby controlling communication and disconnection between the first gas inlet port 211 and the first gas passage section 221 and between the second gas inlet port 212 and the second gas passage section 222, preventing a portion of the first gas from flowing into the first gas passage section 221 when the first gas inlet port 211 is not in communication with the first gas passage section 221, and also preventing a portion of the second gas from flowing into the second gas passage section 222 when the second gas inlet port 212 is not in communication with the second gas passage section 222, thereby helping improve gas isolation during the process.

Moreover, by using the blocking member to block the corresponding gas passage section, while one of the first gas and the second gas flows toward the gas outlet end of the gas inlet assembly 200, the other gas is maintained in a pressurized state. As a result, the gas pressure in the gas passage section corresponding to the pressurized gas gradually increases. When movement of the switching valve plate 220 releases the gas, the gas flows more quickly into the corresponding gas passage section, thereby helping improve the gas switching speed and further improving the process performance.

Of course, in other embodiments, the gas inlet assembly 200 may be provided without a blocking member. When the switching valve plate 220 is at the first position, the switching valve plate 220 directly blocks the second gas inlet port 212, such that the second gas inlet port 212 is not in communication with the gas passage. When the switching valve plate 220 is at the second position, the switching valve plate 220 directly blocks the first gas inlet port 211, such that the first gas inlet port 211 is not in communication with the gas passage.

In some embodiments, a single blocking member is provided, and the position of the blocking member is fixed relative to the gas inlet window 210. When the switching valve plate 220 is at the first position, the blocking member blocks the second gas passage section 222 to prevent the second gas from entering the chamber body 100 through the gas passage. When the switching valve plate 220 is at the second position, the blocking member blocks the first gas passage section 221 to prevent the first gas from entering the chamber body 100 through the gas passage.

In another embodiment, at least two blocking members are provided, including a first blocking member 231 and a second blocking member 232. The first blocking member 231 is disposed at the inlet end of the first gas passage section 221, and the second blocking member 232 is disposed at the inlet end of the second gas passage section 222. The blocking members are elastic structures, and the positions of the first blocking member 231 and the second blocking member 232 are fixed relative to the gas inlet window 210. During movement of the switching valve plate 220, the first blocking member 231 and the second blocking member 232 undergo elastic deformation, thereby changing the shapes of the first blocking member 231 and the second blocking member 232. The deformation state of the first blocking member 231 determines whether the first blocking member 231 blocks the first gas passage section 221. Similarly, the deformation state of the second blocking member 232 determines whether the second blocking member 232 blocks the second gas passage section 222.

When the switching valve plate 220 is at the first position, as shown in FIG. 3, the first blocking member 231 is in an elastically deformed state, and the shape of the first blocking member 231 changes, such that the first blocking member 231 no longer blocks the first gas passage section 221, thereby allowing the first gas inlet port 211 to communicate with the inlet end of the first gas passage section 221. The second blocking member 232 blocks the inlet end of the second gas passage section 222. When the switching valve plate 220 is at the second position, as shown in FIG. 4, the second blocking member 232 is in an elastically deformed state, and the shape of the second blocking member 232 changes, such that the second blocking member 232 no longer blocks the second gas passage section 222, thereby allowing the second gas inlet port 212 to communicate with the inlet end of the second gas passage section 222. The first blocking member 231 blocks the inlet end of the first gas passage section 221.

In some embodiments, when the switching valve plate 220 is at the first position, as shown in FIG. 3, the first blocking member 231 is in a compressed state. Correspondingly, the first blocking member 231 has a relatively small volume and does not block the inlet end of the first gas passage section 221. Meanwhile, the second blocking member 232 does not undergo elastic deformation, i.e., the second blocking member 232 is in an expanded state. Correspondingly, the second blocking member 232 has a relatively large volume and directly blocks the inlet end of the second gas passage section 222. When the switching valve plate 220 is at the second position, as shown in FIG. 4, the first blocking member 231 does not undergo elastic deformation, i.e., the first blocking member 231 is in an expanded state. Correspondingly, the first blocking member 231 has a relatively large volume and directly blocks the inlet end of the first gas passage section 221. Meanwhile, the second blocking member 232 is in a compressed state. Correspondingly, the second blocking member 232 has a relatively small volume and does not block the inlet end of the second gas passage section 222.

In this embodiment, at least two elastic blocking members are provided. Whether a corresponding gas passage section is blocked is determined according to whether the blocking member undergoes elastic deformation. A blocking member that undergoes elastic deformation provides a better blocking effect, thereby improving the sealing performance.

In some other embodiments, the gas inlet assembly 200 further includes a first stopper 241 and a first fixation member 251. The first stopper 241 and the first fixation member 251 are respectively located at opposite sides of the first blocking member 231. The first stopper 241 is connected to the gas inlet window 210, and the first fixation member 251 is connected to the switching valve plate 220. During movement of the switching valve plate 220 from the second position to the first position, the distance between the first stopper 241 and the first fixation member 251 changes. Since the first blocking member 231 is located therebetween, the first stopper 241 and the first fixation member 251 compress the first blocking member 231, causing the first blocking member 231 to undergo elastic deformation. The first stopper 241 and the first fixation member 251 may each have a block-shaped structure, although other structures may also be used. The embodiments of the present disclosure do not specifically limit the structures of the first stopper 241 and the first fixation member 251.

For example, the first stopper 241 may be fixedly connected to the gas inlet window 210 by welding, bonding, or the like, such that the position of the first stopper 241 is fixed relative to the gas inlet window 210. The first fixation member 251 may also be fixedly connected to the switching valve plate 220 by welding, bonding, or the like, such that the first fixation member 251 is fixed relative to the switching valve plate 220 and moves together with the switching valve plate 220.

In this embodiment, whether the first blocking member 231 undergoes elastic deformation is directly controlled according to whether the first stopper 241 and the first fixation member 251 compress the first blocking member 231. That is, whether the first blocking member 231 undergoes elastic deformation is directly controlled by the position of the switching valve plate 220. Correspondingly, the mechanical structure facilitates accurately changing the deformation state of the first blocking member 231 and avoids a situation in which the first blocking member 231 cannot accurately block the first gas passage section 221 due to abnormal conditions, such as a power failure, when an electrical control scheme or the like is used.

Of course, in other embodiments, the first blocking member 231 may be an electrically deformable element, and whether the first blocking member 231 undergoes elastic deformation is controlled according to whether the first blocking member 231 is energized. In some embodiments, the first blocking member 231 may be a thermally deformable element, and whether the first blocking member 231 undergoes elastic deformation is controlled according to whether the first blocking member 231 is heated.

In some embodiments, the gas inlet assembly 200 further includes a second stopper 242 and a second fixation member 252. The second stopper 242 and the second fixation member 252 are respectively located at opposite sides of the second blocking member 232. The second stopper 242 is connected to the gas inlet window 210, and the second fixation member 252 is connected to the switching valve plate 220. During movement of the switching valve plate 220 from the first position to the second position, the distance between the second stopper 242 and the second fixation member 252 changes. Since the second blocking member 232 is located therebetween, the second stopper 242 and the second fixation member 252 compress the second blocking member 232, causing the second blocking member 232 to undergo elastic deformation. The second stopper 242 and the second fixation member 252 may each have a block-shaped structure, although other structures may also be used. The embodiments of the present disclosure do not specifically limit the structures of the second stopper 242 and the second fixation member 252.

For example, the second stopper 242 may be fixedly connected to the gas inlet window 210 by welding, bonding, or the like, such that the position of the second stopper 242 is fixed relative to the gas inlet window 210. The second fixation member 252 may also be fixedly connected to the switching valve plate 220 by welding, bonding, or the like, such that the second fixation member 252 is fixed relative to the switching valve plate 220 and moves together with the switching valve plate 220.

In this embodiment, whether the second blocking member 232 undergoes elastic deformation is directly controlled according to whether the second stopper 242 and the second fixation member 252 compress the second blocking member 232. That is, whether the second blocking member 232 undergoes elastic deformation is directly controlled by the position of the switching valve plate 220. Correspondingly, the mechanical structure facilitates accurately changing the deformation state of the second blocking member 232 and avoids a situation in which the second blocking member 232 cannot accurately block the second gas passage section 222 due to abnormal conditions, such as a power failure, when an electrical control scheme or the like is used.

Of course, in other embodiments, the second blocking member 232 may be an electrically deformable element, and whether the second blocking member 232 undergoes elastic deformation is controlled according to whether the second blocking member 232 is energized. In some embodiments, the second blocking member 232 may be a thermally deformable element, and whether the second blocking member 232 undergoes elastic deformation is controlled according to whether the second blocking member 232 is heated.

In summary, as shown in FIGS. 3 and 4, during movement of the switching valve plate 220 from the second position to the first position, the distance between the first stopper 241 and the first fixation member 251 decreases, and the first blocking member 231 is compressed. Correspondingly, the first blocking member 231 does not block the first gas passage section 221. Meanwhile, the distance between the second stopper 242 and the second fixation member 252 increases, the second blocking member 232 is not compressed, and the second blocking member 232 blocks the second gas passage section 222. The first gas inlet port 211 communicates with the chamber body 100 through the first gas passage section 221, so that the first process can be initiated in the chamber body 100. During movement of the switching valve plate 220 from the first position to the second position, the distance between the first stopper 241 and the first fixation member 251 increases, the first blocking member 231 is not compressed, and therefore the first blocking member 231 blocks the first gas passage section 221. Meanwhile, the distance between the second stopper 242 and the second fixation member 252 decreases, the second blocking member 232 is compressed, and the second blocking member 232 does not block the second gas passage section 222. The second gas inlet port 212 communicates with the chamber body 100 through the second gas passage section 222, so that the second process can be initiated in the chamber body 100.

In some embodiments, as shown in FIGS. 3 and 4, the gas inlet assembly 200 further includes a first sealing member 271. The first sealing member 271 is disposed between the switching valve plate 220 and the gas inlet window 210, and the first sealing member 271 is located between the second gas inlet port 212 and the first gas inlet port 211 so as to isolate the second gas inlet port 212 from the first gas inlet port 211. The first sealing member 271 may be a sealing structure such as a sealing ring or a sealing strip, or may be another sealing structure.

For example, the switching valve plate 220 may be provided with a groove. The first gas inlet port 211 and the second gas inlet port 212 may communicate with the gas passage through the groove. The first sealing member 271 is disposed in the groove and has a strip-shaped structure. Two ends of the first sealing member 271 respectively abut against the groove sidewalls, thereby dividing the groove into two portions. The two portions are respectively in communication with the first gas inlet port 211 and the second gas inlet port 212, thereby providing sealed isolation between the second gas inlet port 212 and the first gas inlet port 211.

In this embodiment, the first sealing member 271 is used to isolate the second gas inlet port 212 from the first gas inlet port 211, thereby preventing gas crossover between the first gas inlet port 211 and the second gas inlet port 212 and helping improve the sealing performance of the gas inlet assembly 200.

In some embodiments, the gas inlet assembly 200 further includes a second sealing member 272. The second sealing member 272 is disposed between the gas inlet window 210 and the switching valve plate 220 to seal the gap therebetween. For example, the second sealing member 272 may be a sealing ring surrounding the first gas inlet port 211 and the second gas inlet port 212. As shown in FIG. 3, the sealing ring surrounds the end of the first gas inlet port 211 adjacent to the first gas passage section 221 and the end of the second gas inlet port 212 adjacent to the second gas passage section 222. In other words, the sealing ring also simultaneously surrounds the first gas passage section 221 and the second gas passage section 222, thereby preventing gas from leaking through the gap between the gas inlet window 210 and the switching valve plate 220. Of course, the second sealing member 272 may also be another sealing structure. In a further embodiment, a second sealing groove is provided on the side of the gas inlet window 210 facing the switching valve plate 220, and the second sealing member 272 is disposed in the second sealing groove.

In this embodiment, the second sealing member 272 is used to seal the gap between the gas inlet window 210 and the switching valve plate 220, thereby preventing the first gas and the second gas from leaking through the gap between the gas inlet window 210 and the switching valve plate 220 and helping improve the sealing performance.

Of course, in some other embodiments, the gas inlet assembly 200 may be provided without the first sealing member 271 and the second sealing member 272. The sealing performance may be improved by increasing the contact tightness between the switching valve plate 220 and the gas inlet window 210, thereby preventing gas crossover and gas leakage.

In the solution of the present disclosure, as shown in FIGS. 2 to 6, the gas inlet assembly 200 further includes a flow equalization plate 260. The flow equalization plate 260 is located at the side of the switching valve plate 220 facing away from the gas inlet window 210. The flow equalization plate 260 is provided with a plurality of flow equalization holes 262, and the gas passage communicates with the gas outlet end of the gas inlet assembly 200 through the flow equalization holes 262.

In this embodiment, the flow equalization holes 262 in the flow equalization plate 260 are used to divide the first gas or the second gas flowing into the switching valve plate 220 into multiple streams, so that the first gas or the second gas flows out more uniformly, thereby helping improve process uniformity.

Of course, in some other embodiments, the gas inlet assembly 200 may be provided without the flow equalization plate 260, and the gas passage of the switching valve plate 220 directly communicates with the gas outlet end of the gas inlet assembly 200.

In some embodiments, the flow equalization holes 262 in the flow equalization plate 260 directly communicate with the gas passage.

In other embodiments, the flow equalization plate 260 is further provided with a flow equalization groove 261. The flow equalization groove 261 and the switching valve plate 220 define a flow equalization space. The flow equalization groove 261 communicates with the plurality of flow equalization holes 262 and the gas passage, i.e., the gas passage communicates with the gas outlet end of the gas inlet assembly 200 through the flow equalization groove 261 and the flow equalization holes 262. For example, the flow equalization groove 261 may be a circular groove or a groove of another shape, provided that it communicates with the respective flow equalization holes 262. In this embodiment, before the process gas introduced through the first gas inlet port 211 or the second gas inlet port 212 enters the flow equalization holes 262, it first diffuses and mixes within the flow equalization groove 261 and is then further equalized through the respective flow equalization holes 262, thereby helping improve the flow equalization performance of the flow equalization plate 260.

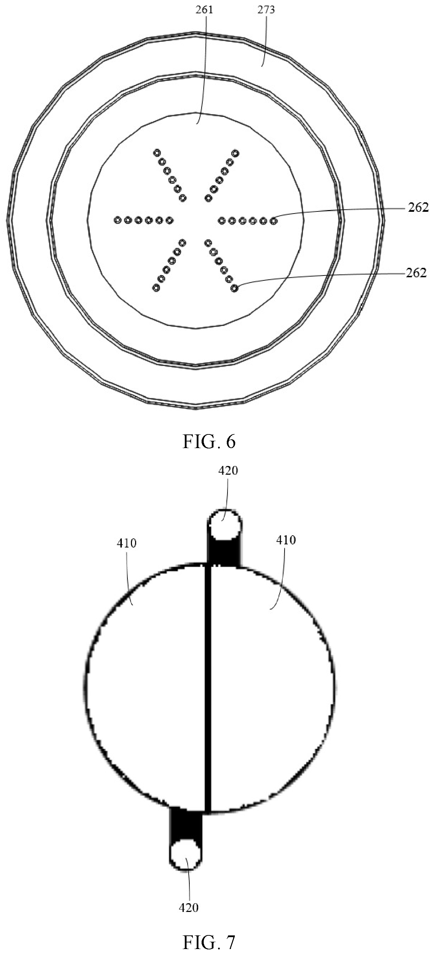

In embodiments in which a plurality of second gas inlet ports 212 and a plurality of first gas inlet ports 211 are provided, as shown in FIGS. 5 and 6, the flow equalization plate 260 is provided with a plurality of flow equalization regions along its circumferential direction. Each flow equalization region is provided with one flow equalization groove 261 and a plurality of flow equalization holes 262. The flow equalization groove 261 corresponds to the first gas inlet port 211 and the second gas inlet port 212 on a one-to-one basis. In other words, when multiple sets of first gas inlet ports 211 and second gas inlet ports 212 are provided, the first gas inlet port 211 and the second gas inlet port 212 in the same set correspond to one flow equalization groove 261.

In some embodiments, the gas inlet assembly 200 further includes a third sealing member 273. The third sealing member 273 is disposed between the flow equalization plate 260 and the switching valve plate 220 to seal the gap therebetween. For example, the third sealing member 273 may be a sealing ring or another sealing structure. A third sealing member 273 is provided outside each flow equalization region of the flow equalization plate 260. In a further embodiment, each flow equalization region of the flow equalization plate 260 is provided with a third sealing groove, and the third sealing member 273 is disposed in the third sealing groove.

In this embodiment, the third sealing member 273 is used to seal the gap between the flow equalization plate 260 and the switching valve plate 220, thereby preventing the first gas and the second gas from leaking through the gap therebetween and further improving the sealing performance.

Of course, in other embodiments, the gas inlet assembly 200 may be provided without the third sealing member 273. The sealing performance may be improved by increasing the contact tightness between the switching valve plate 220 and the flow equalization plate 260, thereby preventing gas crossover and gas leakage.

Based on the gas inlet assembly 200 disclosed in the present disclosure, the embodiments of the present disclosure further provide a semiconductor process chamber. Referring to FIG. 1, the semiconductor process chamber includes the chamber body 100 and the gas inlet assembly 200 described in the foregoing embodiments. The chamber body 100 provides an environment for the semiconductor process, and the interior of the chamber body 100 is a vacuum environment. The gas outlet end of the gas inlet assembly 200 is in communication with the chamber body 100, and the gas inlet assembly 200 is configured to supply process gas into the chamber body 100. For example, the chamber body 100 is provided with a gas inlet port 101, and the gas inlet assembly 200 is disposed at the gas inlet port 101. In a further embodiment, the gas inlet window 210 is located at the gas inlet port 101, and the gas inlet window 210 is configured to close the gas inlet port 101.

In this embodiment, the semiconductor process chamber may be used in a Bosch process. The process gases include an etching gas and a deposition gas. The etching gas may be a fluorine-based gas, and the deposition gas may be a carbon-based gas.

By using the above-described gas inlet assembly 200, the semiconductor process chamber enables rapid switching between the first gas and the second gas, thereby avoiding gas inlet delay in the chamber body 100 and facilitating accurate control of the pressure differential in the chamber body 100 during different processes. For example, the semiconductor process chamber may be used to perform a Bosch etching process to form a high-aspect-ratio hole. Since rapid switching between the etching gas and the deposition gas can be achieved, the sidewall of the etched hole is smoother, thereby helping improve the yield of devices.

For example, as shown in FIG. 1, a base 110 is disposed within the chamber body 100, and the base 110 is configured to carry a wafer 111. The wafer 111 may be a silicon wafer. A liner 120 is provided around the outer periphery of the base 110. The liner 120 prevents the process gas from contaminating the inner wall of the chamber body 100 or other components within the chamber body 100.

In the solution of the present disclosure, as shown in FIG. 1, the chamber body 100 is provided with an exhaust port, and the semiconductor process chamber further includes a pressure control valve 400 disposed at the exhaust port to adjust the opening degree of the exhaust port. The pressure control valve 400 may be a valve body, such as a solenoid valve, a butterfly valve, or a ball valve, capable of performing switching and adjustment functions. The embodiments of the present disclosure do not specifically limit the type of the pressure control valve 400. Correspondingly, by adjusting the pressure control valve 400, the first gas or the second gas that has completed the process is discharged through the exhaust port to the outside of the chamber body 100, thereby facilitating execution of the next process operation in the chamber body 100 and enabling rapid switching between different processes.

In some embodiments, the semiconductor process chamber further includes a vacuum pump 300. An inlet end of the vacuum pump 300 communicates with the exhaust port, and the vacuum pump 300 provides suction power. At least two vacuum pumps 300 are provided, including a dry pump 320 and a molecular pump 310. An inlet end of the molecular pump 310 directly communicates with the exhaust port, and an inlet end of the dry pump 320 directly communicates with an outlet end of the molecular pump 310. The molecular pump 310 is suitable for pumping under a high-vacuum environment, and the dry pump 320 is suitable for pumping under a relatively low-vacuum environment.

In some embodiments, the pressure control valve 400 includes a valve plate 410 and a driving member 420. The driving member 420 is connected to the valve plate 410 and drives the valve plate 410 to rotate, thereby increasing or decreasing the opening degree of the exhaust port. For example, the driving member 420 may be a drive source capable of providing rotational power, such as a motor or a pneumatic motor.

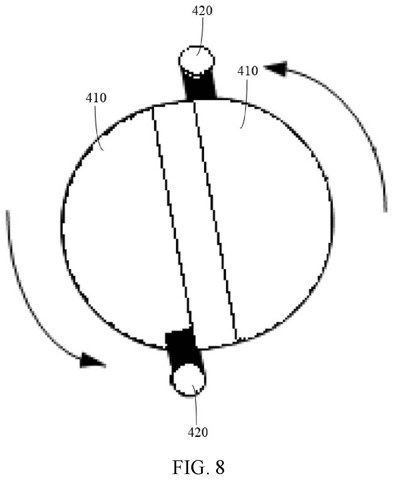

In other embodiments, as shown in FIGS. 7 and 8, the pressure control valve 400 includes at least two valve plates 410 and driving members 420. Each valve plate 410 is rotatably disposed at the exhaust port to open or close the exhaust port. The driving members 420 are respectively connected to the valve plates 410 and are capable of driving the valve plates 410 to rotate simultaneously. The valve plates 410 move toward or away from one another through rotation, thereby increasing or decreasing the opening degree of the exhaust port. For example, at least two driving members 420 are provided, with the driving members 420 corresponding one-to-one with the valve plates 410. Each driving member 420 drives the corresponding valve plate 410 to rotate, thereby moving the valve plates 410 toward or away from one another.

During adjustment of the opening degree of the exhaust port, the at least two valve plates 410 operate simultaneously. Compared with the previous embodiment, the rotational stroke of each valve plate 410 is reduced, i.e., the rotation angle of each valve plate 410 is reduced. Correspondingly, the driving time of the driving members 420 is shortened, the operating time of the pressure control valve 400 is reduced, and the vacuum pump 300 is enabled to perform rapid evacuation, thereby further improving the switching efficiency between the etching process and the deposition process.

In the embodiment shown in FIG. 1, the semiconductor process chamber further includes a first gas mass flow controller 510 and a first gas extraction pipeline 520. A first end of the first gas extraction pipeline 520 and the first gas inlet port 211 respectively communicate with an outlet end of the first gas mass flow controller 510, and a second end of the first gas extraction pipeline 520 communicates with an inlet end of the vacuum pump 300. For example, the first gas inlet port 211 communicates with the outlet end of the first gas mass flow controller 510 through a first pipeline. The first gas mass flow controller 510 controls the flow rate of the first gas entering the first gas inlet port 211. The first end of the first gas extraction pipeline 520 directly communicates with the first pipeline, and the second end of the first gas extraction pipeline 520 communicates with the inlet end of the dry pump 320.

The first gas extraction pipeline 520 is provided with a first control valve 530. For example, the first control valve 530 includes a first needle valve 531 and a first pneumatic shut-off valve 532. The first needle valve 531 and the first pneumatic shut-off valve 532 are disposed at intervals along the first gas extraction pipeline 520. Correspondingly, the first pneumatic shut-off valve 532 controls opening and closing of the first gas extraction pipeline 520, and the first needle valve 531 precisely adjusts the gas flow rate in the first gas extraction pipeline 520.

In this embodiment, when an abnormal condition occurs between the first gas inlet port 211 and the first gas mass flow controller 510 such that the first gas inlet port 211 cannot normally receive the first gas, the first control valve 530 is used to open the first gas extraction pipeline 520, allowing the first gas to enter the vacuum pump 300 through the first gas extraction pipeline 520, thereby preventing excessive gas pressure caused by gas accumulation.

In some embodiments, the semiconductor process chamber further includes a second gas mass flow controller 610 and a second gas extraction pipeline 620. A first end of the second gas extraction pipeline 620 and the second gas inlet port 212 respectively communicate with an outlet end of the second gas mass flow controller 610, and a second end of the second gas extraction pipeline 620 communicates with an inlet end of the vacuum pump 300. For example, the second gas mass flow controller 610 communicates with the outlet end of the second gas mass flow controller 610 through the second pipeline. The second gas mass flow controller 610 controls the flow rate of the second gas entering the second gas inlet port 212. The first end of the second gas extraction pipeline 620 directly communicates with the second pipeline, and the second end of the second gas extraction pipeline 620 communicates with the inlet end of the dry pump 320.

The second gas extraction pipeline 620 is provided with a second control valve 630. For example, the second control valve 630 includes a second needle valve 631 and a second pneumatic shut-off valve 632. The second needle valve 631 and the second pneumatic shut-off valve 632 are disposed at intervals along the second gas extraction pipeline 620. Correspondingly, the second pneumatic shut-off valve 632 controls opening and closing of the second gas extraction pipeline 620, and the second needle valve 631 precisely adjusts the gas flow rate in the second gas extraction pipeline 620.

In this embodiment, when an abnormal condition occurs between the second gas inlet port 212 and the second gas mass flow controller 610 such that the second gas inlet port 212 cannot normally receive the second gas, the second control valve 630 is used to open the second gas extraction pipeline 620, allowing the second gas to enter the vacuum pump 300 through the second gas extraction pipeline 620, thereby preventing excessive gas pressure caused by gas accumulation.

In some embodiments, the semiconductor process chamber further includes a pressure detection element. The pressure detection element is disposed within the chamber body 100 to detect the gas pressure therein. The pressure detection element may be, but is not limited to, a pressure sensor. The pressure detection element is communicatively connected to the pressure control valve 400. When the first gas inlet port 211 is in communication with the gas passage, the opening degree of the pressure control valve 400 is a first opening degree corresponding to the pressure value detected by the pressure detection element, such that the chamber body 100 is maintained at a first pressure value. When the second gas inlet port 212 is in communication with the gas passage, the opening degree of the pressure control valve 400 is a second opening degree corresponding to the pressure value detected by the pressure detection element, such that the chamber body 100 is maintained at a second pressure value. The difference between the first pressure value and the second pressure value is within a preset pressure difference range.

For example, the pressure control range of the pressure control valve 400 may be 30 mTorr to 200 mTorr. The first pressure value may be 75 mTorr, the second pressure value may be 55 mTorr, and the preset pressure difference range may be 10 mTorr to 30 mTorr. The difference between the first pressure value and the second pressure value is 20 mTorr, and therefore the pressure difference between the two is within the preset pressure difference range. Of course, the first pressure value and the second pressure value may also be other values, and the preset pressure difference range may be set as needed.

It should be noted that, during the etching process, the higher the pressure in the chamber body 100, the higher the etching rate. During the deposition process, the lower the pressure in the chamber body 100, the higher the deposition uniformity. Under ideal conditions, when the difference between the first pressure value and the second pressure value reaches 150 mTorr, the etching rate and throughput are higher.

In this embodiment, the opening degree of the pressure control valve 400 is adjusted according to the pressure in the chamber body 100, so that the chamber body 100 is maintained at an appropriate pressure value during the first process and the second process, respectively. This facilitates maintaining the pressure difference in the chamber body 100 during the first process and the second process within an appropriate range, thereby helping achieve both process efficiency and process uniformity.

In some embodiments, the semiconductor process chamber further includes a controller. The controller includes at least one memory and at least one processor. A computer program is stored in the memory. When the computer program is executed by the processor, the processes of the semiconductor process method are implemented. The semiconductor process method includes:

When the first process operation is performed, the switching valve plate 220 is controlled to move to the first position, such that the first gas enters the chamber body 100 through the first gas inlet port 211. When the second process operation is performed, the switching valve plate 220 is controlled to move to the second position, such that the second gas enters the chamber body 100 through the second gas inlet port 212.

For example, the controller may be a host computer or a lower-level controller. The controller may directly control the switching valve plate 220, or may control a driving member that drives movement of the switching valve plate 220, so that the switching valve plate 220 moves to the first position or the second position, thereby introducing the corresponding process gas into the chamber body 100.

In this embodiment, the controller is used to implement automatic switching of the position of the switching valve plate 220, thereby facilitating rapid switching of the position of the switching valve plate 220 and, in turn, rapid switching between the first process operation and the second process operation. This further shortens the switching time between the first gas and the second gas, more effectively avoids the problem of gas inlet delay in the chamber body 100, and enables the pressure control process of the chamber body 100 during the first process operation and the second process operation to be performed more quickly and accurately, thereby improving the process performance.

In a further embodiment, the first process operation is an etching process, the first gas is an etching gas, the second process operation is a deposition process, and the second gas is a deposition gas. The semiconductor process method further includes alternately performing the first process operation and the second process operation, i.e., alternately performing the etching process and the deposition process.

In this embodiment, the controller continuously switches the switching valve plate 220 between the first position and the second position, thereby achieving rapid switching between the etching process and the deposition process. During alternating execution of the etching process and the deposition process, the gas inlet delay associated with each process operation is effectively avoided, the overall process duration is effectively shortened, and the process control of the chamber body 100 during each process operation is performed more quickly and accurately, thereby further improving the process performance.

In the related art, because the first gas or the second gas is introduced into the chamber body 100 through a pipeline, there is a delay before the first gas and the second gas enter the chamber body 100. Correspondingly, the pressure detection element also detects the pressure value in the chamber body 100 with a delay, and the pressure control valve 400 correspondingly operates with a delay. Since both the gas inlet process and the pressure control process are delayed, radio frequency power also needs to be applied with a delay, resulting in an increased duration of each cycle of the Bosch process. In addition, due to the delay, it is difficult to control the pressure difference in the chamber body 100 during the etching process and the deposition process.

In the embodiments of the present disclosure, the semiconductor process method includes alternately performing the first process operation and the second process operation. Specifically, the second process operation includes controlling the switching valve plate 220 to move to the second position, such that the second gas inlet port 212 communicates with the chamber body 100 through the gas passage, allowing the second gas to enter the chamber body 100 through the second gas inlet port 212. The first process operation includes controlling the switching valve plate 220 to move to the first position, such that the first gas inlet port 211 communicates with the chamber body 100 through the gas passage, allowing the first gas to enter the chamber body 100 through the first gas inlet port 211.

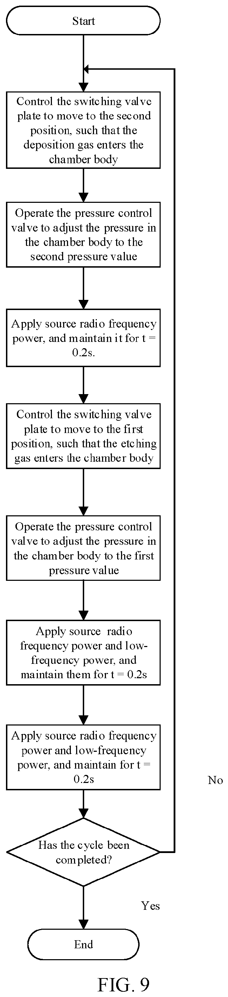

For example, the first process operation is an etching process, and the second process operation is a deposition process. The semiconductor process method is the Bosch process, which includes a plurality of cycles, each cycle including the above-described deposition process and etching process. For example, the etching process includes a first etching process and a second etching process, as shown in FIG. 9.

The deposition process includes: controlling the switching valve plate 220 to move to the second position, such that the deposition gas rapidly enters the chamber body 100. Meanwhile, the pressure detection element detects the pressure value in the chamber body 100, and the pressure control valve 400 adjusts its opening degree according to the detected pressure value to maintain the chamber body 100 at the second pressure value. Source radio frequency power is then applied and maintained for t = 0.2 s. In this process, deposition gases such as Ar and C₄F₈ are typically used to form a fluorocarbon polymer layer on the sidewalls of the holes in the wafer 111. To substantially prevent formation of the fluorocarbon polymer layer at the bottoms of the holes, a relatively low radio frequency is generally used in this process.

The first etching process includes: controlling the switching valve plate 220 to move to the first position, such that the etching gas rapidly enters the chamber body 100. Meanwhile, the pressure detection element detects the pressure value in the chamber body 100, and the pressure control valve 400 adjusts its opening degree according to the detected pressure value to maintain the chamber body 100 at the first pressure value. Source radio frequency power and low-frequency power are then sequentially applied and maintained for t = 0.2 s. The difference between the first pressure value and the second pressure value is within the preset pressure difference range.

The second etching process includes: continuing to sequentially apply source radio frequency power and low-frequency power, which are maintained for t = 0.2 s. The etching process typically uses gases such as Ar, O₂, and SF₆ to perform plasma etching.

The number of cycles of the Bosch process may be set as needed. Upon completion of the preset number of cycles, one process is completed. That is, the etching process and the deposition process are performed alternately. When the etching process is completed, the etching gas is discharged from the chamber body 100 while the deposition gas is simultaneously introduced. Similarly, when the deposition process is completed, the deposition gas is discharged from the chamber body 100 while the etching gas is simultaneously introduced, and the cycle is repeated correspondingly.

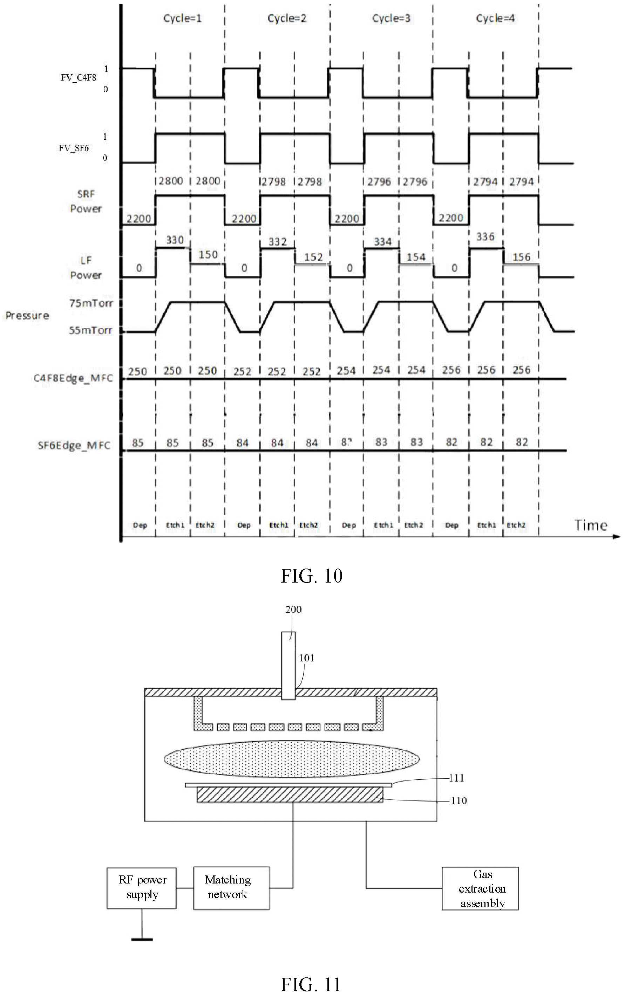

FIG. 10 shows a timing diagram of four process cycles, in which the second gas mass flow controller 610 controls the flow rate of the second gas to be 250 sccm, and the first gas mass flow controller 510 controls the flow rate of the first gas to be 85 sccm. During the deposition process, the radio frequency voltage of the applied source radio frequency power is 2200 dBW. During the etching process, the radio frequency voltage of the applied source radio frequency power is 2794 dBW to 2800 dBW. During the first etching process, the radio frequency voltage of the low-frequency power is 330 dBW to 336 dBW. During the deposition process, the pressure in the chamber body 100 is 75 mTorr, and during the etching process, the pressure in the chamber body 100 is 55 mTorr. During the process, the pressure in the chamber body 100 exhibits a trapezoidal square-wave waveform.

By adopting the above process flow, movement of the switching valve plate 220 is directly used to control the first gas or the second gas entering the chamber body 100, thereby effectively preventing residual gas from the previous process from entering the chamber body and participating in the subsequent process, preventing the two process gases from mixing during the process, and substantially eliminating any delay in introducing the first gas and the second gas into the chamber body 100. Correspondingly, the pressure detection element does not need to delay detection of the pressure value, and radio frequency power does not need to be applied with a delay, thereby effectively shortening the overall duration of the semiconductor process method and facilitating control of the pressure difference in the chamber body 100 during the first process operation and the second process operation. In addition, the control procedure of the semiconductor process method is simplified, the number of recipe parameters for the semiconductor process method is reduced, and the development difficulty of the semiconductor process method is effectively reduced.

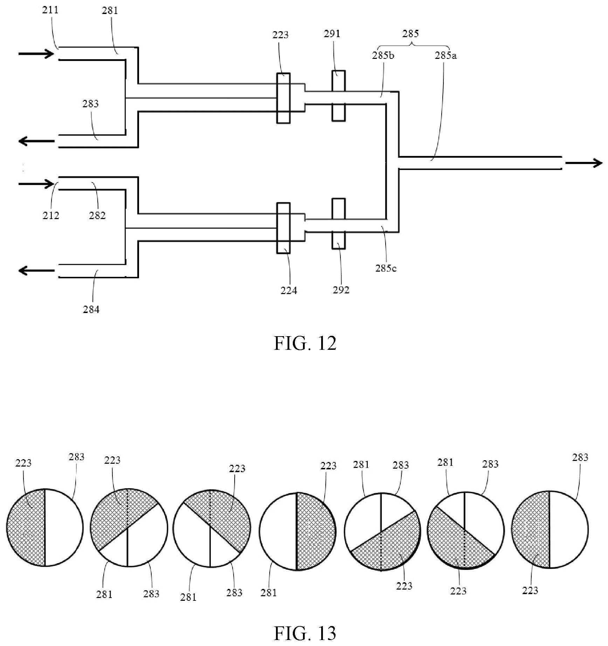

In some other embodiments of the present disclosure, as shown in FIGS. 12 and 13, the gas inlet assembly 200 includes a first gas inlet unit and a second gas inlet unit. The first gas inlet unit and the second gas inlet unit are alternately in communication with the gas outlet end of the gas inlet assembly 200.

The first gas inlet unit includes a first gas inlet pipe 281, a first gas extraction pipe 283, and a first switching valve plate 223. An inlet end of the first gas inlet pipe 281 serves as the first gas inlet port 211, and the first gas inlet pipe 281 is configured to receive the first gas. An inlet port of the first gas extraction pipe 283 and an outlet port of the first gas inlet pipe 281 are arranged side by side. The first switching valve plate 223 is rotatably disposed at the inlet port of the first gas extraction pipe 283 and the outlet port of the first gas inlet pipe 281. When the first switching valve plate 223 rotates to different positions, the inlet port of the first gas extraction pipe 283 and the outlet port of the first gas inlet pipe 281 can be selectively opened. In this way, by changing the rotational position of the first switching valve plate 223, the outlet port of the first gas inlet pipe 281 and the inlet port of the first gas extraction pipe 283 are directly controlled, without separately controlling the first gas inlet pipe 281 and the first gas extraction pipe 283.

The second gas inlet unit includes a second gas inlet pipe 282, a second gas extraction pipe 284, and a second switching valve plate 224. An inlet end of the second gas inlet pipe 282 serves as the second gas inlet port 212, and the second gas inlet pipe 282 is configured to receive the second gas. An inlet port of the second gas extraction pipe 284 and an outlet port of the second gas inlet pipe 282 are arranged side by side. The second switching valve plate 224 is rotatably disposed at the inlet port of the second gas extraction pipe 284 and the outlet port of the second gas inlet pipe 282. When the second switching valve plate 224 rotates to different positions, the inlet port of the second gas extraction pipe 284 and the outlet port of the second gas inlet pipe 282 can be selectively opened. In this way, by changing the rotational position of the second switching valve plate 224, the outlet port of the second gas inlet pipe 282 and the inlet port of the second gas extraction pipe 284 are directly controlled, without separately controlling the second gas inlet pipe 282 and the second gas extraction pipe 284.

For example, the first switching valve plate 223 and the second switching valve plate 224 may be respectively connected to drive sources capable of providing rotational power, such as motors or pneumatic motors, and the drive sources are used to drive rotation of the first switching valve plate 223 or the second switching valve plate 224. In a further embodiment, the linear driving members described above for driving movement of the switching valve plate 220, or the drive sources described herein, may be controlled by the controller. The controller controls the states of the two linear driving members or the two drive sources, thereby causing the first gas inlet unit and the second gas inlet unit to alternately introduce gas.

In this embodiment, the first gas inlet unit and the second gas inlet unit are alternately in communication with the gas outlet end of the gas inlet assembly 200. When the first gas inlet unit is in communication with the gas outlet end of the gas inlet assembly 200, the second switching valve plate 224 can rotate to a position at which the second gas extraction pipe 284 is opened. The second gas extraction pipe 284 extracts gas from the second gas inlet pipe 282, i.e., extracts the process gas from the second gas inlet pipe 282, thereby preventing residual process gas from entering the chamber body 100 and mixing with the process gas of the subsequent process to participate in the subsequent process. Similarly, when the second gas inlet unit is in communication with the gas outlet end of the gas inlet assembly 200, the first switching valve plate 223 can rotate to a position at which the first gas extraction pipe 283 is opened. The first gas extraction pipe 283 extracts gas from the first gas inlet pipe 281, i.e., extracts the process gas from the first gas inlet pipe 281, thereby preventing residual process gas from the previous process from entering the chamber body 100 and mixing with the process gas of the subsequent process to participate in the subsequent process, thereby helping improve the process performance.

For example, the first gas inlet pipe 281 may receive an etching gas, and the second gas inlet pipe 282 may receive a deposition gas. The two processes are an etching process and a deposition process, respectively. In the Bosch etching process, switching between the etching process and the deposition process can effectively prevent an uneven scalloped structure from being formed on the sidewall of a deep hole produced by etching, making the sidewall of the deep hole smoother, avoiding adverse effects on subsequent processes, helping improve the process performance, and thereby helping improve the yield of devices. Of course, the first gas inlet port 211 and the second gas inlet port 212 may also respectively receive other different types of process gases.

In some other embodiments, when the first gas inlet unit is in communication with the gas outlet end of the gas inlet assembly 200, the first switching valve plate 223 is located at a position blocking the inlet port of the first gas extraction pipe 283, such that the first gas extraction pipe 283 is unable to perform gas extraction. In this embodiment, by blocking the first gas extraction pipe 283, gas in the chamber body 100 is prevented from being extracted by the first gas extraction pipe 283, thereby avoiding adverse effects on the process.

For example, when the first gas inlet unit is in communication with the gas outlet end of the gas inlet assembly 200, the first switching valve plate 223 is positioned to open the first gas inlet pipe 281, allowing the first gas inlet pipe 281 to receive gas. In this way, because the first gas extraction pipe 283 is blocked, gas in the first gas inlet pipe 281 is prevented from being extracted by the first gas extraction pipe 283, thereby ensuring that the first process gas entering through the first gas inlet pipe 281 is smoothly introduced into the chamber body 100.

Of course, in other embodiments, an outlet port of the first gas extraction pipe 283 is connected to a first extraction pump. When the first gas inlet unit is in communication with the gas outlet end of the gas inlet assembly 200, the first switching valve plate 223 is positioned to open the inlet port of the first gas extraction pipe 283, and the first extraction pump is in a non-operating state.

In a further embodiment, when the first gas inlet unit is in communication with the gas outlet end of the gas inlet assembly 200, the first gas inlet unit supplies process gas into the chamber body 100, and the second switching valve plate 224 is in a rotating state. For example, the plane of rotation of the second switching valve plate 224 is parallel to the plane in which the outlet port of the second gas inlet pipe 282 is located and is also parallel to the plane in which the inlet port of the second gas extraction pipe 284 is located.

Specifically, when the second switching valve plate 224 is in the rotating state, that is, while the second switching valve plate 224 is rotating, both the outlet port of the second gas inlet pipe 282 and the inlet port of the second gas extraction pipe 284 each have three states: fully open, partially open, and fully blocked. When the outlet port of the second gas inlet pipe 282 is fully open, the inlet port of the second gas extraction pipe 284 is fully blocked. When the outlet port of the second gas inlet pipe 282 is partially open, the inlet port of the second gas extraction pipe 284 is also partially open, that is, partially blocked. When the outlet port of the second gas inlet pipe 282 is fully blocked, the inlet port of the second gas extraction pipe 284 is fully open. Through rotation, the second switching valve plate 224 continuously switches the outlet port of the second gas inlet pipe 282 and the inlet port of the second gas extraction pipe 284 among the three states of fully open, partially open, and fully blocked.

In this embodiment, when the first gas inlet unit introduces gas, the rotating second switching valve plate 224 gradually opens the second gas inlet pipe 282 while gradually closing the second gas extraction pipe 284, and also gradually closes the second gas inlet pipe 282 while gradually opening the second gas extraction pipe 284, allowing the second gas extraction pipe 284 to extract the residual gas in the second gas inlet pipe 282, thereby preventing the residual gas in the second gas inlet pipe 282 from affecting the process. Meanwhile, because the second switching valve plate 224 remains in the rotating state, the pipeline of the second gas inlet unit is prevented from remaining in a pressurized state. Correspondingly, when the duration of a single process operation is relatively long, hardware damage caused by the pipeline remaining in the pressurized state for an extended period can be avoided.

For example, the inlet port of the first gas extraction pipe 283 and the outlet port of the first gas inlet pipe 281 each have a semicircular structure, and together form a circular structure. The first switching valve plate 223 has a semicircular structure and rotates about the axis of the circular structure. The inlet port of the first gas extraction pipe 283 and the outlet port of the first gas inlet pipe 281 are arranged in alignment. With this structure, during rotation, the first switching valve plate 223 can completely overlap the inlet port of the first gas extraction pipe 283, thereby completely blocking the inlet port of the first gas extraction pipe 283, or the first switching valve plate 223 can completely overlap the outlet port of the first gas inlet pipe 281, thereby completely blocking the outlet port of the first gas inlet pipe 281, which helps simplify the structure of the gas inlet assembly 200.

Of course, the inlet port of the first gas extraction pipe 283, the outlet port of the first gas inlet pipe 281, and the first switching valve plate 223 may also have a square structure or another structure.

In a further embodiment, as shown in FIG. 12, the first gas inlet unit further includes a third control valve 291 and a first pipe section 285b. The first pipe section 285b is positioned opposite the inlet port of the first gas extraction pipe 283 and the outlet port of the first gas inlet pipe 281. The third control valve 291 is disposed at the first pipe section 285b, and the third control valve 291 controls opening and closing of the first pipe section 285b. In the gas inlet direction of the first gas inlet pipe 281, the third control valve 291 is located downstream of the first switching valve plate 223. When the first gas inlet unit is in communication with the gas outlet end of the gas inlet assembly 200, the third control valve 291 is in an open state, thereby ensuring that the first process gas is smoothly introduced into the chamber body 100. When the second gas inlet unit is in communication with the gas outlet end of the gas inlet assembly 200, the third control valve 291 is in a closed state, thereby preventing the second process gas and the first process gas from mixing before entering the chamber body 100 and affecting the process.

In some other embodiments, when the second gas inlet unit is in communication with the gas outlet end of the gas inlet assembly 200, the second switching valve plate 224 is located at a position blocking the inlet port of the second gas extraction pipe 284, such that the second gas extraction pipe 284 is unable to perform gas extraction. In this embodiment, by blocking the second gas extraction pipe 284, gas in the chamber body 100 is prevented from being extracted by the second gas extraction pipe 284, thereby avoiding adverse effects on the process.

For example, when the second gas inlet unit is in communication with the gas outlet end of the gas inlet assembly 200, the second switching valve plate 224 is positioned to open the second gas inlet pipe 282, allowing the second gas inlet pipe 282 to receive gas. In this way, because the second gas extraction pipe 284 is blocked, gas in the second gas inlet pipe 282 is prevented from being extracted by the second gas extraction pipe 284, thereby ensuring that the second process gas entering through the second gas inlet pipe 282 is smoothly introduced into the chamber body 100.

Of course, in other embodiments, an outlet port of the second gas extraction pipe 284 is connected to a second extraction pump. When the second gas inlet unit is in communication with the gas outlet end of the gas inlet assembly 200, the second switching valve plate 224 is positioned to open the inlet port of the second gas extraction pipe 284, and the second extraction pump is in a non-operating state.

In a further embodiment, when the second gas inlet unit is in communication with the gas outlet end of the gas inlet assembly 200, the second gas inlet unit supplies process gas into the chamber body 100, and the first switching valve plate 223 is in a rotating state. For example, the plane of rotation of the first switching valve plate 223 is parallel to the plane in which the outlet port of the first gas inlet pipe 281 is located and is also parallel to the plane in which the inlet port of the first gas extraction pipe 283 is located.

Specifically, as shown in FIG. 13, when the first switching valve plate 223 is in the rotating state, that is, while the first switching valve plate 223 is rotating, both the outlet port of the first gas inlet pipe 281 and the inlet port of the first gas extraction pipe 283 each have three states: fully open, partially open, and fully blocked. When the outlet port of the first gas inlet pipe 281 is fully open, the inlet port of the first gas extraction pipe 283 is fully blocked. When the outlet port of the first gas inlet pipe 281 is partially open, the inlet port of the first gas extraction pipe 283 is also partially open, that is, partially blocked. When the outlet port of the first gas inlet pipe 281 is fully blocked, the inlet port of the first gas extraction pipe 283 is fully open. Through rotation, the first switching valve plate 223 causes the outlet port of the first gas inlet pipe 281 and the inlet port of the first gas extraction pipe 283 to switch among the three states of fully open, partially open, and fully blocked.

In this embodiment, when the second gas inlet unit introduces gas, the rotating first switching valve plate 223 gradually opens the first gas inlet pipe 281 while gradually closing the first gas extraction pipe 283, and also gradually closes the first gas inlet pipe 281 while gradually opening the first gas extraction pipe 283, allowing the first gas extraction pipe 283 to extract the residual gas in the first gas inlet pipe 281, thereby preventing the residual gas in the first gas inlet pipe 281 from affecting the process. Meanwhile, because the first switching valve plate 223 remains in the rotating state, the pipeline of the first gas inlet unit is prevented from remaining in a pressurized state. Correspondingly, when the duration of a single process operation is relatively long, hardware damage caused by the pipeline remaining in the pressurized state for an extended period can be avoided.

For example, the inlet port of the second gas extraction pipe 284 and the outlet port of the second gas inlet pipe 282 each have a semicircular structure, and together form a circular structure. The second switching valve plate 224 has a semicircular structure and rotates about the axis of the circular structure. The inlet port of the second gas extraction pipe 284 and the outlet port of the second gas inlet pipe 282 are arranged in alignment. With this structure, during rotation, the second switching valve plate 224 can completely overlap the inlet port of the second gas extraction pipe 284, thereby completely blocking the inlet port of the second gas extraction pipe 284, or the second switching valve plate 224 can completely overlap the outlet port of the second gas inlet pipe 282, thereby completely blocking the outlet port of the second gas inlet pipe 282, which helps simplify the structure of the gas inlet assembly 200.

Of course, the inlet port of the second gas extraction pipe 284, the outlet port of the second gas inlet pipe 282, and the second switching valve plate 224 may also have a square structure or another structure.

In a further embodiment, the second gas inlet unit further includes a fourth control valve 292 and a second pipe section 285c. The second pipe section 285c is positioned opposite the inlet port of the second gas extraction pipe 284 and the outlet port of the second gas inlet pipe 282. The fourth control valve 292 is disposed at the second pipe section 285c, and the fourth control valve 292 controls opening and closing of the second pipe section 285c. In the gas inlet direction of the second gas inlet pipe 282, the fourth control valve 292 is located downstream of the second switching valve plate 224. When the second gas inlet unit is in communication with the gas outlet end of the gas inlet assembly 200, the fourth control valve 292 is in an open state, thereby ensuring that the second process gas is smoothly introduced into the chamber body 100. When the first gas inlet unit is in communication with the gas outlet end of the gas inlet assembly 200, the fourth control valve 292 is in a closed state, thereby preventing the first process gas and the second process gas from mixing before entering the chamber body 100 and affecting the process.

For example, the gas inlet assembly 200 further includes a gas outlet pipe 285. The gas outlet pipe 285 includes the main pipeline 285a, the above-described first pipe section 285b, and the second pipe section 285c. The first pipe section 285b and the second pipe section 285c respectively communicate with the main pipeline 285a. Correspondingly, the first gas flowing through the first gas inlet pipe 281 or the second gas flowing through the second gas inlet pipe 282 flows out through the corresponding pipe section and the main pipeline 285a.

In summary, when the first process is initiated, the third control valve 291 is in an open state, the first switching valve plate 223 opens the first gas inlet pipe 281 and blocks the first gas extraction pipe 283, and the first gas enters the chamber body to perform, for example, the etching process. Meanwhile, the fourth control valve 292 is in a closed state, and the second switching valve plate 224 rotates to rapidly switch between the gas inlet process and the gas extraction process, thereby preventing the pipeline of the second gas inlet unit from remaining in a pressurized state. When the second process is initiated, the third control valve 291 is in a closed state, and the first switching valve plate 223 rotates to rapidly switch between the gas inlet process and the gas extraction process, thereby preventing the pipeline of the first gas inlet unit from remaining in a pressurized state. Meanwhile, the fourth control valve 292 is in an open state, the second switching valve plate 224 opens the second gas inlet pipe 282 and blocks the second gas extraction pipe 284, and the second gas enters the chamber body to perform, for example, the deposition process.

Based on the gas inlet assembly 200 in the above embodiments, the embodiments of the present disclosure further provide a semiconductor process chamber. As shown in FIG. 11, the semiconductor process chamber includes the chamber body 100 and the gas inlet assembly 200 in the above embodiments. The chamber body 100 is provided with a gas inlet port 101, and the gas inlet assembly 200 is disposed at the gas inlet port 101. That is, the main pipeline 285a of the gas outlet pipe 285 communicates with the gas inlet port 101 of the chamber body 100. Correspondingly, by using the gas inlet assembly 200, the semiconductor process chamber prevents residual process gas from the previous process from entering the chamber body 100 and mixing with the process gas of the subsequent process to participate in the subsequent process, thereby helping improve the process performance.

Based on the gas inlet assembly 200 in the above embodiments, the embodiments of the present disclosure further provide a semiconductor process method. The semiconductor process method includes a first process operation and a second process operation.

The first process operation includes: controlling the first gas inlet unit to be in communication with the gas outlet end of the gas inlet assembly 200, such that the first switching valve plate 223 is located at a position blocking the inlet port of the first gas extraction pipe 283, and the second switching valve plate 224 is in a rotating state. Specifically, at this time, the first switching valve plate 223 is also positioned to open the first gas inlet pipe 281, allowing the first gas inlet pipe 281 to receive the first process gas, and the first process gas can be introduced into the chamber body 100. In addition, through rotation of the second switching valve plate 224, the second gas extraction pipe 284 is able to extract the residual gas in the second gas inlet unit.

The second process operation includes: controlling the second gas inlet unit to be in communication with the gas outlet end of the gas inlet assembly 200, such that the second switching valve plate 224 is located at a position blocking the inlet port of the second gas extraction pipe 284, and the first switching valve plate 223 is in a rotating state. Specifically, at this time, the second switching valve plate 224 is also positioned to open the second gas inlet pipe 282, allowing the second gas inlet pipe 282 to receive the second process gas, and the second process gas can be introduced into the chamber body 100. In addition, through rotation of the first switching valve plate 223, the first gas extraction pipe 283 is able to extract the residual gas in the first gas inlet unit.

For example, the first process gas may be an etching gas, and the second process gas may be a deposition gas. The first process operation may be an etching process, and the second process operation may be a deposition process. The semiconductor process method is the Bosch process, which includes a plurality of cycles, each cycle including the above-described deposition process and etching process.

By adopting the above semiconductor process method, the gas extraction pipe is used to perform gas extraction, thereby effectively preventing residual gas from the previous process from entering the chamber body 100 and participating in the subsequent process, preventing the two process gases from mixing during the process, and helping improve the process performance.

The embodiments of the present disclosure have been described above with reference to the accompanying drawings. However, the present disclosure is not limited to the specific embodiments described above. The specific embodiments described above are merely illustrative rather than limiting. Under the teachings of the present disclosure, a person of ordinary skill in the art may make many variations without departing from the spirit of the present disclosure and the scope protected by the claims, and all such variations fall within the scope of the present disclosure.

## Claims

1. A gas inlet assembly, comprising a gas inlet window and a switching valve plate connected to each other, wherein the gas inlet window is provided with a first gas inlet port and a second gas inlet port, the switching valve plate is movable relative to the gas inlet window between a first position and a second position, and the switching valve plate is provided with a gas passage, the gas passage communicating with a gas outlet end of the gas inlet assembly;
when the switching valve plate is at the first position, the first gas inlet port is in communication with the gas passage and the second gas inlet port is disconnected from the gas passage; and
when the switching valve plate is at the second position, the second gas inlet port is in communication with the gas passage and the first gas inlet port is disconnected from the gas passage.

2. The gas inlet assembly according to claim 1, comprising a blocking member, wherein the blocking member is disposed between the gas inlet window and the switching valve plate, the gas passage includes a first gas passage section and a second gas passage section, and an outlet end of the first gas passage section and an outlet end of the second gas passage section are respectively in communication with the gas outlet end of the gas inlet assembly;
when the switching valve plate is at the first position, the first gas inlet port is in communication with an inlet end of the first gas passage section, and the blocking member blocks an inlet end of the second gas passage section; and
when the switching valve plate is at the second position, the second gas inlet port is in communication with an inlet end of the second gas passage section, and the blocking member blocks an inlet end of the first gas passage section.

3. The gas inlet assembly according to claim 2, wherein there are at least two blocking members, the at least two blocking members including a first blocking member and a second blocking member, the first blocking member is disposed at the inlet end of the first gas passage section, the second blocking member is disposed at the inlet end of the second gas passage section, and the blocking members are elastic structures;
when the switching valve plate is at the first position, the first blocking member is in an elastically deformed state, such that the first gas inlet port is in communication with the inlet end of the first gas passage section, and the second blocking member blocks the inlet end of the second gas passage section; and
when the switching valve plate is at the second position, the second blocking member is in an elastically deformed state, such that the second gas inlet port is in communication with the inlet end of the second gas passage section, and the first blocking member blocks the inlet end of the first gas passage section.

4. The gas inlet assembly according to claim 3, further comprising a first stopper and a first fixation member, the first stopper and the first fixation member being respectively located at opposite sides of the first blocking member, the first stopper being connected to the gas inlet window, the first fixation member being connected to the switching valve plate, and during movement of the switching valve plate from the second position to the first position, the first stopper and the first fixation member compressing the first blocking member, such that the first blocking member undergoes elastic deformation;
and/or, the gas inlet assembly further comprising a second stopper and a second fixation member, the second stopper and the second fixation member being respectively located at opposite sides of the second blocking member, the second stopper being connected to the gas inlet window, the second fixation member being connected to the switching valve plate, and during movement of the switching valve plate from the first position to the second position, the second stopper and the second fixation member compressing the second blocking member, such that the second blocking member undergoes elastic deformation.

5. The gas inlet assembly according to claim 1, wherein the first gas inlet port and the second gas inlet port are arranged in pairs, and a plurality of pairs of first gas inlet ports and second gas inlet ports are circumferentially spaced around the gas inlet window;
a plurality of gas passages are arranged at intervals, each gas passage corresponding to a respective pair of first gas inlet port and second gas inlet port.

6. The gas inlet assembly according to claim 1, wherein the gas inlet assembly further includes a first sealing member, the first sealing member is disposed between the gas inlet window and the switching valve plate, and the first sealing member is located between the second gas inlet port and the first gas inlet port so as to isolate the second gas inlet port from the first gas inlet port;
and/or, the gas inlet assembly further includes a second sealing member, the second sealing member is disposed between the gas inlet window and the switching valve plate so as to seal a gap between the gas inlet window and the switching valve plate.

7. The gas inlet assembly according to any one of claims 1 to 6, further comprising a flow equalization plate, the flow equalization plate being located at a side of the switching valve plate facing away from the gas inlet window, the flow equalization plate is provided with a plurality of flow equalization holes, and the gas passage communicates with the gas outlet end of the gas inlet assembly through the flow equalization holes.

8. The gas inlet assembly according to claim 7, wherein the flow equalization plate is further provided with a flow equalization groove, the flow equalization groove and the switching valve plate define a flow equalization space, and the flow equalization groove communicates with the plurality of flow equalization holes and the gas passage.

9. The gas inlet assembly according to claim 7, further comprising a third sealing member, the third sealing member being disposed between the flow equalization plate and the switching valve plate so as to seal a gap between the flow equalization plate and the switching valve plate.

10. A gas inlet assembly, comprising a first gas inlet unit and a second gas inlet unit, wherein:
the first gas inlet unit includes a first gas inlet pipe, a first gas extraction pipe, and a first switching valve plate, an inlet port of the first gas extraction pipe and an outlet port of the first gas inlet pipe are arranged side by side, and the first switching valve plate is rotatably disposed at the inlet port of the first gas extraction pipe and the outlet port of the first gas inlet pipe;
the second gas inlet unit includes a second gas inlet pipe, a second gas extraction pipe, and a second switching valve plate, an inlet port of the second gas extraction pipe and an outlet port of the second gas inlet pipe are arranged side by side, and the second switching valve plate is rotatably disposed at the inlet port of the second gas extraction pipe and the outlet port of the second gas inlet pipe; and
the first gas inlet unit and the second gas inlet unit are alternately in communication with a gas outlet end of the gas inlet assembly.

11. The gas inlet assembly according to claim 10, wherein, when the first gas inlet unit is in communication with the gas outlet end of the gas inlet assembly, the first switching valve plate is located at a position blocking the inlet port of the first gas extraction pipe; and
when the second gas inlet unit is in communication with the gas outlet end of the gas inlet assembly, the second switching valve plate is located at a position blocking the inlet port of the second gas extraction pipe.

12. The gas inlet assembly according to claim 11, wherein, when the first gas inlet unit is in communication with the gas outlet end of the gas inlet assembly, the second switching valve plate is in a rotating state; and
when the second gas inlet unit is in communication with the gas outlet end of the gas inlet assembly, the first switching valve plate is in a rotating state.

13. The gas inlet assembly according to claim 10, wherein the inlet port of the first gas extraction pipe and the outlet port of the first gas inlet pipe each have a semicircular structure and together form a circular structure, and the first switching valve plate has a semicircular structure;
and/or, the inlet port of the second gas extraction pipe and the outlet port of the second gas inlet pipe each have a semicircular structure and together form a circular structure, and the second switching valve plate has a semicircular structure.

14. The gas inlet assembly according to claim 10, wherein the first gas inlet unit further includes a third control valve and a first pipe section, the first pipe section is positioned opposite the inlet port of the first gas extraction pipe and the outlet port of the first gas inlet pipe, the third control valve is disposed at the first pipe section, and, when the first gas inlet unit is in communication with the gas outlet end of the gas inlet assembly, the third control valve is in an open state;
and/or, the second gas inlet unit further includes a fourth control valve and a second pipe section, the second pipe section is positioned opposite the inlet port of the second gas extraction pipe and the outlet port of the second gas inlet pipe, the fourth control valve is disposed at the second pipe section, and, when the second gas inlet unit is in communication with the gas outlet end of the gas inlet assembly, the fourth control valve is in an open state.

15. A semiconductor process chamber, comprising the gas inlet assembly according to any one of claims 1 to 14 and a chamber body, wherein a gas outlet end of the gas inlet assembly is in communication with the chamber body.

16. The semiconductor process chamber according to claim 15, wherein the chamber body is provided with an exhaust port, and the semiconductor process chamber further includes a pressure control valve disposed at the exhaust port to adjust an opening degree of the exhaust port.

17. The semiconductor process chamber according to claim 16, wherein the pressure control valve includes at least two valve plates and two driving members, each valve plate is rotatably disposed at the exhaust port to open or close the exhaust port, each driving member is connected to a respective valve plate, and the driving member is capable of driving the respective valve plate to rotate simultaneously, thereby increasing or decreasing the opening degree of the exhaust port.

18. A semiconductor process method, applied to the gas inlet assembly according to any one of claims 1 to 9, comprising:
a first process operation, controlling the switching valve plate to move to a first position, such that a first gas enters a chamber body through a first gas inlet port;
a second process operation, controlling the switching valve plate to move to a second position, such that a second gas enters the chamber body through a second gas inlet port; and
alternately performing the first process operation and the second process operation.

19. A semiconductor process method, applied to the gas inlet assembly according to any one of claims 10 to 14, comprising:
a first process operation, controlling the first gas inlet unit to be in communication with a gas outlet end of the gas inlet assembly, such that a first switching valve plate is located at a position blocking an inlet port of a first gas extraction pipe, and a second switching valve plate is in a rotating state; and
a second process operation, controlling the second gas inlet unit to be in communication with the gas outlet end of the gas inlet assembly, such that the second switching valve plate is located at a position blocking an inlet port of the second gas extraction pipe, and the first switching valve plate is in a rotating state.
